# EUROPÄISCHE PATENTSCHRIFT

(11) **EP 1 956 647 B1**
(45) Veröffentlichungstag und Bekanntmachung des Hinweises auf die Patenterteilung: **12.08.2009**
(21) Anmeldenummer: 08000989.7
(22) Anmeldetag: 19.01.2008
(51) Int. Cl.: H01L 21/60

(54) **Schaltungsanordnung mit Verbindungseinrichtung sowie Herstellungsverfahren hierzu**
Circuit arrangement with connecting device and corresponding production method
Circuit doté d'un dispositif de liaison et son procédé de fabrication

(30) Priorität: 10.02.2007 DE 102007006706
(43) Veröffentlichungstag der Anmeldung: 13.08.2008
(73) Patentinhaber: SEMIKRON Elektronik GmbH & Co. KG, 90431 Nürnberg (DE)
(72) Erfinder: Beckedahl, Peter, 90522 Oberasbach (DE); Braml, Heiko, 91346 Wiesenttal (DE); Göbl, Christian, 90441 Nürnberg (DE); Heilbronner, Heinrich, Dr., 90547 Stein (DE)

(56) Entgegenhaltungen:
- WO-A-03/030247
- DE-B3-7102004 019 56
- US-A1- 2004 227 235
- US-A1- 2006 103 000

## Beschreibung

Die Erfindung beschreibt eine Schaltungsanordnung mit Verbindungseinrichtung zur elektrisch leitenden Verbindung von Halbleiterbauelementen mit den Leiterbahnen eines Substrats, wobei die Verbindungseinrichtung mit einer metallischen Folie ausgebildet ist. Weiterhin wird ein vorteilhaftes Verfahren zur Herstellung einer derartigen Schaltungsanordnung beschrieben.

Es ist eine Vielzahl von Verbindungseinrichtungen für elektronische Bauelemente bekannt. Bei gehausten Bauelementen sind beispielhaft metallische Verbindungseinrichtungen und deren löttechnische Verbindung mit Substraten bekannt, wobei hier unter Substraten auch jegliche Art von Leiterplatten verstanden werden soll.

Bei ungehausten Bauelementen ist als Verbindungseinrichtung die Drahtbondverbindung weit verbreitet. Im Bereich von Leistungshalbleitermodulen sind weiterhin formschlüssige Verbindungen, als sog. Druckkontaktierung bekannt. Ebenfalls von Leistungshalbleitermodulen sind druckkontaktierte flexible Leiterplatten als Verbindungseinrichtungen bekannt. Die DE 102 21 970 A1 offenbart ein Leistungshalbleitermodul mit einer derartigen Verbindungseinrichtung, lässt allerdings deren exakte Ausgestaltung offen.

Die DE 103 55 925 A1 offenbart eine Verbindungseinrichtung für Leistungshalbleiterbauelemente bestehend aus einem Folienverbund einer ersten und einer zweiten elektrisch leitenden Folie mit einer isolierenden Zwischenlage. Die Leistungshalbleiterbauelemente sind mit der ersten leitenden Schicht mittels Ultraschallschweißen dauerhaft sicher elektrisch verbunden. Die modulinteme schaltungsgerechte Verbindung der Leistungshalbleiterbauelemente mit Leiterbahnen eines Substrats ist hierbei mittels metallischer Kontaktelemente ausgebildet deren Dicke derjenigen der Leistungshalbleiterbauelemente angepassten ist. Diese Kontaktelemente werden ebenfalls wie die Leistungshalbleiterbauelemente mittels Ultraschallschweißen mit der Verbindungseinrichtung verbunden.

Die leitende Folie zur Ultraschallschweißverbindung mit Leistungshalbleiterbauelement und Kontaktelemente besteht hierbei aus Aluminium mit Prägenoppen, da Aluminium eine vorzügliche Schweißverbindung mit der ebenfalls aus einer letzten Lage Aluminium bestehenden Metallisierung des Leistungshalbleiterbauelements eingeht.

Weiterhin sind beispielhaft aus der DE 34 14 065 C2 und der DE 10 2004 019 567 A1 Drucksinterverfahren bekannt, welche eine dauerhafte Verbindung zwischen einem Leistungshalbleiterbauelement und einem Anschlusselement oder einem Substrat offenbaren. Das Verfahren gemäß der DE 10 2004 019 567 A1 ist gekennzeichnete durch die wesentlichen Verfahrensschritte: Aufbringen einer aus einem Metallpulver und einem Lösungsmittel bestehenden pastösen Schicht auf eine Trägerfolie; Trocknen der pastösen Schicht; Aufbringen von mindestens einem Bauelement auf die getrocknete Schicht; Druckbeaufschlagung des Verbundes aus dem Bauelement und der Trägerfolie mit der getrockneten Schicht, wodurch die Haftkraft zwischen der Schicht und dem Bauelement größer wird als zwischen der Schicht und der Trägerfolie (10); Abheben des mindestens einen Bauelements mit daran haftender Schicht von der Trägerfolie; Positionierung des Bauelements mit der daran haftenden Schicht auf dem Substrat; Druckbeaufschlagung der Anordnung des Substrats und des Bauelements zu deren Sinterverbindung.

Die US 2004/0227235 A1 beschreibt eine Schaltungsanordnung mit einem Substrat mit Leiterbahnen und einem Halbleiterbauelement, einer elektrisch leitfähigen Verbindung zwischen einer Kontaktstelle auf dem Halbleiterbauelement und dem Substrat. Die Verbindung ist hierbei mittels eine Gieß- oder verwandten Verfahrens angeordnet und hierzu ein Isolierstoff zwischen dem Rand des Halbleiterbauelements und der Verbindungseinrichtung auf dem Substrat angeordnet.

Das Dokument WO 03/030247 A2 offenbart als Verbindungseinrichtung eines Substrats mit einem Halbleiterbauelement eine hierauf auflaminierte isolierende Folie mit Kontaktausnehmungen. Hierzu wird die isolierende Folie bündig auf das Substrat und das Halbleiterbauelement unter Vakuum auflaminiert und anschließend die notwendigen Kontaktflächen von der isolierenden Folie freigelegt werden. Die freigelegten Kontaktflächen des Substrates werden mit einer elektrisch leitenden Kontaktschicht bedeckt und verbunden.

Der Erfindung liegt die Aufgabe zugrunde eine Schaltungsanordnung mit Verbindungseinrichtung für die Verbindung mindestens eines Halbleiterbauelements beispielhaft mit einer Leiterbahn eines Substrats sowie derer Herstellungsverfahren vorzustellen, wobei diese Schaltungsanordnung einer einfachen Herstellung zugänglich ist und die elektrischen Verbindungen innerhalb dieser Schaltungsanordnung eine hohe Zuverlässigkeit aufweisen.

Diese Aufgabe wird erfindungsgemäß gelöst, durch Schaltungsanordnung gemäß Anspruch 1 sowie durch ein Herstellungsverfahren gemäß Anspruch 6. Bevorzugte Ausführungsformen sind in den Unteransprüchen beschrieben.

Ausgangspunkt der erfindungsgemäßen Schaltungsanordnung ist ein Substrat mit auf einer Hauptfläche angeordneten Leiterbahnen. Auf diesen Leiterbahnen ist mindestens ein Halbleiterbauelement angeordnet. Die erste Kontaktfläche auf der ersten Hauptfläche dieses Halbleiterbauelements ist hierzu mit einer ersten Leiterbahn des Substrats, vorzugsweise elektrisch leitend, verbunden. Vorteilhafterweise ist diese Verbindung als Drucksinterverbindung ausgebildet.

Die Schaltungsanordnung weist weiterhin eine elektrisch leitfähige Verbindungseinrichtung zwischen mindestens einer Kontaktfläche auf der zweiten Hauptfläche des Halbleiterbauelement und beispielhaft einer zweiten Leiterbahn auf. Hierbei ist die elektrische Verbindung zwischen der Verbindungseinrichtung und der zweiten Leiterbahn ebenfalls als Drucksinterverbindung ausgebildet.

Besonders vorteilhaft ist es, wenn auch die elektrisch leitende Verbindung der Kontaktflächen der zweiten Hauptfläche des Halbleiterbauelements mit der Verbindungseinrichtung als Drucksinterverbindungen ausgebildet sind. Für die Ausbildung dieser Drucksinterverbindungen innerhalb der genannten Schaltungsanordnung weist das Herstellungsverfahren mit den folgenden wesentlichen Schritten besondere Vorteile auf:
- Ausbildung einer Mehrzahl von Sintermetallflächen auf Leiterbahnen des Substrats. Derartige Sintermetallflächen können vorzugsweise im Rahmen eines Sieb- oder Schablonendruckprozesses auf das Substrat aufgebracht werden.
- Anordnung mindestens eines Halbleiterbauelements auf einer zugeordneten Sintermetallfläche. Hierbei kann es vorteilhaft sein, wenn die zweite Hauptfläche des Halbleiterbauelements bereits ebenfalls mit einer Sintermetallfläche versehen ist.
- Anordnung des Isolierstoffes, vorzugsweise einer Silikonverbindung, speziell einem Silikonkautschuk, im Randbereich des Halbleiterbauelements. Hierbei sind speziell Spritz- oder Gießverfahren vorteilhaft an die sich eine Vernetzung beispielhaft durch UV- Belichtung anschließt.
- Anordnung der Verbindungseinrichtung. Aufbringen der Verbindungseinrichtung zur schaltungsgerechten elektrischen Verbindung der Halbleiterbauelemente und der Leiterbahnen des Substrats. Hierbei ist es vorteilhafte wenn die Verbindungseinrichtung eine hohe Funktionalität aufweist. Hierzu kann diese mehrlagig ausgebildet sein.
- Drucksinterverbindung der Verbindungseinrichtung und des Halbleiterbauelements, wodurch eine Mehrzahl von elektrisch leitenden Verbindungen gleichzeitig ausgebildet wird.

Hierbei kommt der Anordnung des Isolierstoffes, der vorzugsweise eine Silikonverbindung ist, besondere Wichtigkeit zu. Ohne diesen Isolierstoff besteht bei der Druckbeaufschlagung im Rahmen der Drucksinterverbindung die Gefahr, dass die Ränder des Halbleiterbauelements beschädigt werden. Durch die Anordnung dieses lsolierstoffes, wird der auf ihn eingeleitete Druck an den Grenzflächen auf alle anschließenden Oberflächen quasihydrostatisch verteilt. Somit wirkt der Druck nicht nur aus Richtung der Druckeinleitung die typischerweise senkrecht zur Substratoberfläche erfolgt, sondern beaufschlagt beispielhaft den Rand des Halbleiterbauelements aus allen Richtungen annähernd gleich stark.

Durch die geeignet Menge des lsolierstoffes füllt dieser in der Schaltungsanordnung das Volumen begrenzt durch das Substrat, der Verbindungseinrichtung und dem Halbleiterbauelement. Somit ist einerseits eine zerstörende Druckeinleitung auf den Rand des Halbleiterbauelements verhindert und andererseits eine elektrische Isolation gegeben, wobei der Isolierstoff vorteilhafterweise eine höhere Dielektrizitätskonstante als Luft aufweist.

Besonders bevorzugte Weiterbildungen dieser Schaltungsanordnung sowie des Herstellungsverfahrens sind in der jeweiligen Beschreibung der Ausführungsbeispiele genannt. Die erfinderische Lösung wird zudem an Hand der Ausführungsbeispiele der Fig. 1 bis 6 weiter erläutert.

Fig. 1 zeigt einen Querschnitt durch eine erste Ausgestaltung einer erfindungsgemäßen Schaltungsanordnung.

Fig. 2 zeigt eine Draufsicht auf die erste Ausgestaltung der erfindungsgemäßen Schaltungsanordnung.

Fig. 3 zeigt einen Querschnitt durch eine zweite Ausgestaltung einer erfindungsgemäßen Schaltungsanordnung.

Fig. 4 zeigt eine Draufsicht auf die zweite Ausgestaltung der erfindungsgemäßen Schaltungsanordnung.

Fig. 5 zeigt einen Querschnitt durch eine dritte Ausgestaltung einer erfindungsgemäßen Schaltungsanordnung.

Fig. 6 zeigt einen Querschnitt durch eine vierte Ausgestaltung einer erfindungsgemäßen Schaltungsanordnung.

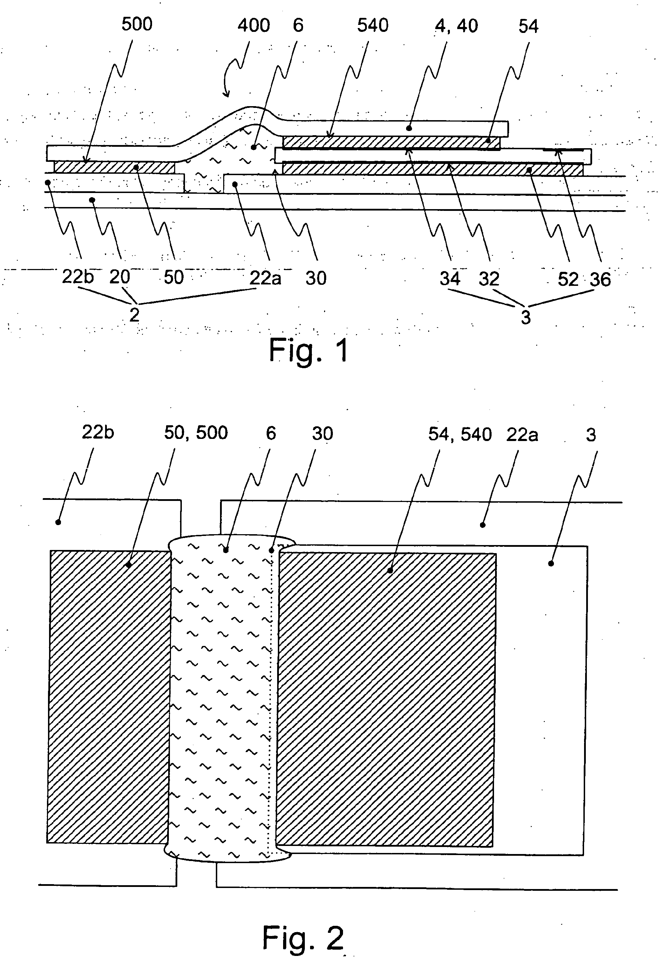

Fig. 1 zeigt einen nicht maßstäblichen Querschnitt durch eine erste Ausgestaltung einer erfindungsgemäßen Schaltungsanordnung. Dargestellt ist hierbei ein Substrat (2), wie es häufig als sog. DCB- (direct copper bonding) oder IMS- (integrated metal substrate) Substrat bekannt ist, ohne dass dieses eine Beschränkung auf derartige Substrate bedeuten soll. Dargestellt ist eine isolierende Lage (20) mit hierauf angeordneten Leiterbahnen (22 a/b) des Substrats (2). Eine dieser Leiterbahnen (22a) trägt hier ein vorzugsweise ungehaustes Halbleiterbauelement (3), beispielsweise einen Leistungstransistor wie er häufig zur Ansteuerung von Drehstrommotoren eingesetzt wird.

Zur elektrisch leitenden Verbindung zwischen der ersten das Halbleiterbauelement tragenden Leiterbahn (22a) und einer Kontaktfläche (32) auf der ersten Hauptfläche des Halbleiterbauelements (3) ist eine Sintermetallfläche (52) angeordnet. Diese Sintermetallfläche (52) stellt durch den Drucksinterprozess der Herstellung eine elektrisch leitende Verbindung hoher Zuverlässigkeit dar.

Die zweite Hauptfläche des Halbleiterbauelements weist zwei Kontaktflächen (34, 36) auf. Eine erste großflächige Emitteranschlussfläche (34) und eine weitere kleinere Anschlussfläche (36) des Gateanschlusses. Auf der zweiten Kontaktfläche (32) ist wiederum eine Sintermetallfläche (54) angeordnet. Diese dient der elektrischen Verbindung mit einer Verbindungseinrichtung (4).

Diese Verbindungseinrichtung (4) ist hier als metallische Folie (40), vorzugsweise aus Kupfer mit Edelmetallbeschichtung im Bereich (500, 540) der Sinterverbindungen (50, 54) ausgebildet. Die Dicke dieser metallischen Folie (40) ist derart gewählt, dass sie mindestens die gleiche Stromtragfähigkeit aufweist wie eine Drahtbondverbindung nach dem Stand der Technik.

Die Verbindungseinrichtung (4) stellt die elektrische Verbindung zwischen der zweiten Hauptfläche bzw. der zweiten Kontaktfläche (34) des Halbleiterbauelements (3) und einer zweiten Leiterbahn (22b) des Substrats (2) dar. Die Verbindung zur zweiten Leiterbahn (22b) ist ebenfalls als Drucksinterverbindung ausgebildet. Vorzugsweise weist die metallische Folie (40) einen bogenförmigen Verlauf (46) zwischen den beiden Kontaktflächen (500, 540) auf.

In dem Volumenbereich der durch den bogenförmigen Verlauf (400) der Verbindungseinrichtung (4), dem Substrat (2) und dem Halbleiterbauelement (3) gebildet wird ist ein lsolierstoff (6) angeordnet. Dieser lsolierstoff (6) wurde während des Herstellungsprozesses in demjenigen Bereich aufgebracht der anschließend von einer Verbindungseinrichtung (4) überdeckt wird. Bei dieser Ausgestaltung ist dies der Bereich eines Randes (30) des Halbleiterbauelements (3).

Vorzugsweise ist der verwendete lsolierstoff (6) eine mehrkomponentige Silikonverbindung, die in einem Gießverfahren am Rand des Halbleiterbauelements (3) aufgetragen wurde und mittels einer UV- Belichtung vernetzt wurde. Somit ist einerseits eine gewisse Zähigkeit des Isolierstoffs (6) gegeben, und andererseits eignet sich eine derartige Silikonverbindung auch zur inneren Isolation, falls die Schaltungsanordnung für entsprechend hohe Spannungen entworfen wurde.

Fig. 2 zeigt eine Draufsicht auf die erste Ausgestaltung der erfindungsgemäßen Schaltungsanordnung. Dargestellt sind hierbei die gleichen Teile der Schaltungsanordnung wie unter Fig. 1 beschrieben.

Hierbei ist die flächige Ausdehnung des lsolierstoffes (6) im Bereich zwischen den Kontaktflächen (500, 540) der Verbindungseinrichtung (4) mit der Leiterbahn (22b) sowie dem Halbleiterbauelement bzw. dessen zweiter Kontaktfläche (54) sowie auch im Bereich neben der Verbindungseinrichtung (4) dargestellt. Nicht explizit dargestellt ist die Ausbildung der Verbindungseinrichtung (4), die das Halbleiterbauelement der dem Isolierstoff (6) zugewandten Rand überragt und dort die Verbindung zur zweiten Leiterbahn (22b) herstellt.

Gemäß dieser Ausgestaltung dient der Isolierstoff (6) einerseits bei einer flächigen Druckeinleitung im Rahmen der Drucksinterverbindung in Richtung der Zeichnungsebene als quasihydostatisches Element, das den Druck an seinen Grenzflächen gleichmäßig verteilt und somit einer Beschädigung des Halbleiterbauelement (3) während der Druckbeaufschlagung verhindert. Anderseits dient er auch der bereits beschrieben elektrischen Isolation der erfindungsgemäßen Schaltungsanordnung.

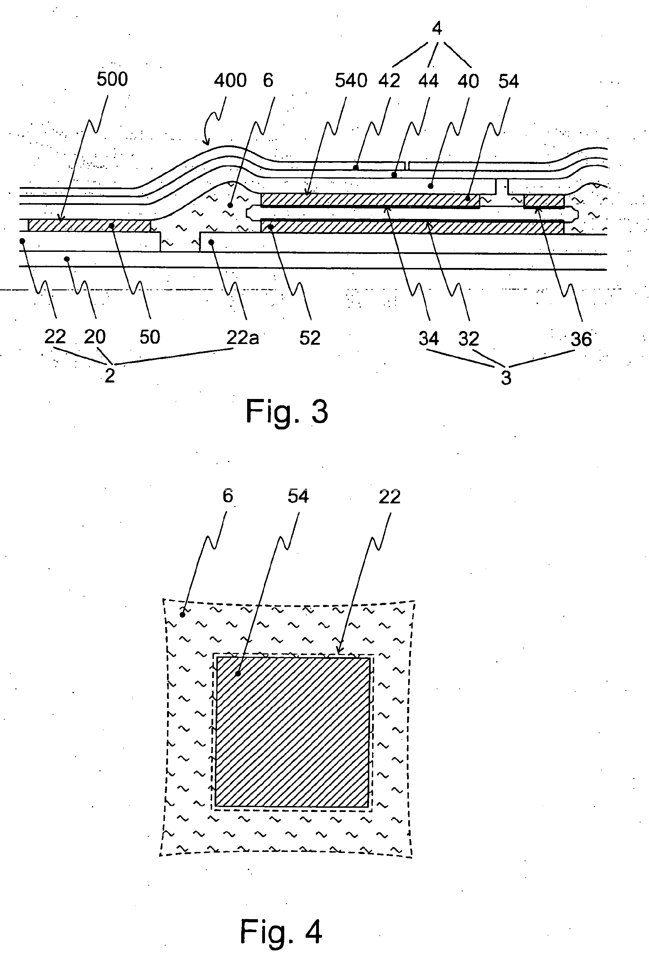

Fig. 3 zeigt einen Querschnitt durch eine zweite Ausgestaltung einer erfindungsgemäßen Schaltungsanordnung. Hierbei ist das Substrat (2) identisch demjenigen gemäß Fig. 1. In dieser Ausbildung ist das Halbleiterbauelement (3) allerdings als Leistungsthyristor in MESA Struktur ausgestaltet.

: Die Verbindungseinrichtung (4) weist hier zusätzlich zu einer ersten metallischen Folie (40) wie in Fig. 1 dargestellt noch eine weitere von der ersten (40) durch eine isolierende Folie (44) getrennte metallische Folie auf (42). Dieser Folienverbund erweitert die Funktionalität der Verbindungseinrichtung (4) beispielhaft um eine Leitung zur Gateansteuerung und bei Bedarf noch um weitere Leitungen vorzugsweise im Bereich der zweiten metallischen Folie (42).

Weiterhin kann es bevorzugt sein, wie hier dargestellt, dass die Verbindungseinrichtung (4) das Halbleiterbauelement (3) an mehr als einer Rand überragt. Hierdurch kann beispielhaft eine Mehrzahl von Halbleiterbauelementen (3) selektiv angesteuert werden. Hierbei ist es bevorzugt, wenn der Isolationsstoff den Rand des Halbleiterbauelements (3) vollständig umschließt, wie in Fig. 4 gezeigt, wobei hier allerdings auf die Darstellung der Verbindungseinrichtung verzichtet wurde.

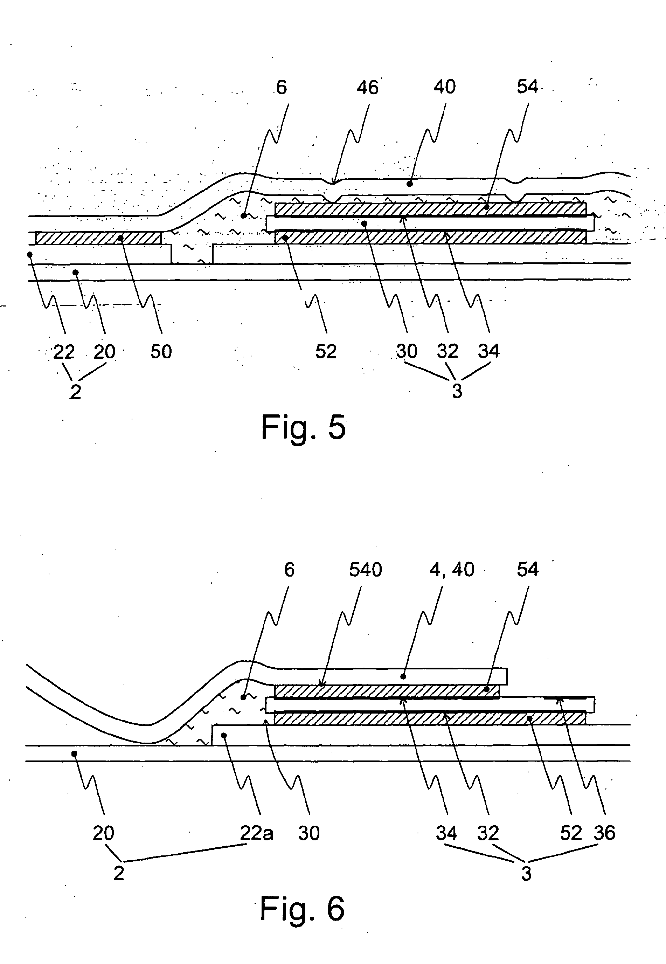

Fig. 5 zeigt einen Querschnitt durch eine dritte Ausgestaltung einer erfindungsgemäßen Schaltungsanordnung. Hierbei ist im Gegensatz zur Ausgestaltung gemäß Fig. 1 die elektrisch leitende Verbindung zwischen der Verbindungseinrichtung (4) und der zweiten Kontaktfläche (34) des Halbleiterbauelement (3) als Punktschweißverbindung von Prägenoppen (46) der metallischen Folie (40) ausgebildet.

Hierbei wird während des Herstellungsprozesses die Verbindungseinrichtung (4) gemeinsam mit hieran angeordneten Halbleiterbauelementen (3) auf dem Substrat (2) angeordnet. Zusätzlich dient hierbei der lsolationsstoff (6) als Zwischenlage zwischen der metallischen Folie (40) der Verbindungseinrichtung (4) und dem Halbleiterbauelement (3).

Fig. 6 zeigt einen Querschnitt durch eine vierte Ausgestaltung einer erfindungsgemäßen Schaltungsanordnung. Im Gegensatz zur Ausgestaltung gemäß Fig. 1 stellt hier die Verbindungseinrichtung (4) eine Verbindung zwischen einer Kontaktfläche (34) eines Halbleiterbauelement (3) und einer nicht auf dem Substrat (2) angeordneten Kontaktfläche, beispielsweise auf einem nicht dargestellten Anschlusselement zur externen Verbindung her.

Hierbei ist es ebenfalls bevorzugt, wenn der Isolierstoff in dem Volumen begrenzt durch das Substrat (2), die Verbindungseinrichtung (4) selbst und das Halbleiterbauelement (3) angeordnet ist.

## Patentansprüche

1. Schaltungsanordnung mit einem Substrat (2),
auf einer Hauptfläche dieses Substrats (2) angeordneten Leiterbahnen (22 a/b), mindestens einem mit seiner ersten Hauptfläche auf einer ersten Leiterbahn (22a) angeordnetem Halbleiterbauelement (3),
einer elektrisch leitfähigen Verbindungseinrichtung (4) zu mindestens einer Kontaktfläche (34, 36) der zweiten Hauptfläche des Halbleiterbauelement (3) wobei die Verbindung des Halbleiterbauelements (3) mit der Verbindungseinrichtung (4) als Drucksinterverbindung ausgebildet ist und wobei
zwischen der Verbindungseinrichtung und einem zugeordneten Rand (30) des Halbleiterbauelements (3) ein Isolierstoff (6) angeordnet ist,
hierbei die Verbindungseinrichtung (4) als metallische Folie (40) oder als Folienverbund aus mindestens einer metallischen (40, 42) und einer isolierenden Folie (44) ausgebildet ist .

2. Schaltungsanordnung nach Anspruch 1,
wobei der Isolierstoff (6) als Silikonverbindung ausgebildet ist.

3. Schaltungsanordnung nach Anspruch 1,
wobei
eine elektrische Verbindung zwischen der Verbindungseinrichtung (4) und einer zweiten Leiterbahn (22b) als Drucksinterverbindung ausgebildet ist und hierbei in dem Volumen begrenzt durch das Substrat (2), die Verbindungseinrichtung (4) und das Halbleiterbauelement (3) der Isolierstoff (6) angeordnet ist.

4. Schaltungsanordnung nach Anspruch 1,
wobei die Verbindungseinrichtung (4) das Halbleiterbauelement (3) an einem Rand (30) überlappt und dort die Verbindung zur zweiten Leiterbahn (22b) ausgebildet ist.

5. Schaltungsanordnung nach Anspruch 1,
wobei die Verbindungseinrichtung (4) eine Mehrzahl von Halbleiterbauelementen (3) überdeckt.

6. Verfahren zur Herstellung einer Schaltungsanordnung nach Anspruch 1 mit den wesentlichen Schritten:
• Ausbildung einer Mehrzahl von Sintermetallflächen (50, 52) auf Leiterbahnen (22 a/b) des Substrats (2);
• Anordnung mindestens eines Halbleiterbauelement (3) auf einer zugeordneten Sinterrnetallfläche (52);
• Anordnung des Isolierstoffes (6) im Randbereich (30) des mindestens einen Halbleiterbauelements (3);
• Anordnung der Verbindungseinrichtung (4), welche als metallische folie (40) oder als folie verbund ans mindestens eine metallischen (40,42) und einen isolierenden folie (44) ausgebildet ist, zur schaltungsgerechten elektrischen verbindung des mindestens einen Halbleiterbauelements (3) und der Leiterbahnen (22 a/b) des Substrats (2);
• Herstellung einer Drucksinterverbindung zwischen Verbindungseinrichtung (4) und dem mindestens einen Halbleiterbauelement (3).

7. Verfahren nach Anspruch 6,
wobei auf der zweiten Hauptfläche des Halbleiterbauelements (3) vor der Anordnung auf dem Substrat (2) eine Siniermetallfläche (54) ausgebildet wird.

8. Verfahren nach Anspruch 7,
wobei der Isolierstoff (6) in einem Spritz- oder Gießverfahren angeordnet wird.

## Claims

1. Circuit arrangement with
a substrate (2),
conductor tracks (22 a/b) arranged on a main surface of this substrate (2), at least one semiconductor module (3) arranged with its first main surface on a first conductor track (22a),
an electrically conductive connection device (4) connected to at least one contact surface (34, 36) of the second main surface of the semiconductor module (3), wherein the connection of the semiconductor module (3) to the connection device (4) is constructed as a pressure sintered connection and wherein
an insulating material (6) is arranged between the connection device and an assigned edge (30) of the semiconductor module (3),
in the process, the connection device (4) is constructed as a metallic foil (40) or as a foil composite made from at least one metallic (40, 42) and an insulating foil (44).

2. Circuit arrangement according to Claim 1,
wherein the insulating material (6) is configured as a silicone compound.

3. Circuit arrangement according to Claim 1,
wherein
an electrical connection between the connection device (4) and a second conductor track (22b) is constructed as a pressure sintered connection and the insulating material (6) in the volume is here arranged so that it is delimited by the substrate (2), the connection device (4) and the semiconductor module (3).

4. Circuit arrangement according to Claim 1,
wherein the connection device (4) overlaps the semiconductor module (3) at an edge (30) and the connection to the second conductor track (22b) is constructed there.

5. Circuit arrangement according to Claim 1,
wherein the connection device (4) covers a plurality of semiconductor modules (3).

6. Method for producing a circuit arrangement according to Claim 1 with the essential steps:
• Construction of a plurality of sintered metal surfaces (50, 52) on conductor tracks (22 a/b) of the substrate (2) ;
• Arrangement of at least one semiconductor module (3) on an assigned sintered metal surface (52);
• Arrangement of the insulating material (6) in the edge region (30) of the at least one semiconductor element (3);
• Arrangement of the connection device (4), which is constructed as a metallic foil (40) or as a foil composite made from at least one metallic (40, 42) and an insulating foil (44), for the electrical connection of the at least one semiconductor module (3) and the conductor tracks (22 a/b) of the substrate (2) in a manner suitable for the circuit;
• Production of a pressure sintered connection between the connection device (4) and the at least one semiconductor element (3).

7. Method according to Claim 6,
wherein a sintered metal surface (54) is constructed on the second main surface of the semiconductor module (3) before the arrangement on the substrate (2).

8. Method according to Claim 7,
wherein the insulating material (6) is arranged in an injection moulding or moulding process.

## Revendications

1. Agencement de circuit comprenant
un substrat (2),
des pistes conductrices (22 a/b) disposées sur une surface principale de ce substrat (2),
au moins un composant à semi-conducteur (3) disposé avec sa première surface principale sur une première piste conductrice (22a),
un dispositif de liaison (4) électroconducteur pour au moins une surface de contact (34, 36) de la seconde surface principale du composant à semi-conducteur (3), la liaison du composant à semi-conducteur (3) avec le dispositif de liaison (4) étant conçue sous forme de liaison à frittage de pression, et un matériau isolant (6) étant disposé entre le dispositif de liaison et un bord (30) associé du composant à semi-conducteur (3),
le dispositif de liaison (4) étant conçu ici sous forme de film (40) métallique ou sous forme d'assemblage de films constitué d'au moins un film métallique (40, 42) et d'un film isolant (44).

2. Agencement de circuit selon la revendication 1, le matériau isolant (6) étant conçu sous forme de liaison à silicone.

3. Agencement de circuit selon la revendication 1, une liaison électrique entre le dispositif de liaison (4) et une seconde piste conductrice (22b) étant conçue sous forme de liaison à frittage sous pression et le matériau isolant (6) étant disposé ici dans le volume délimité par le substrat (2), le dispositif de liaison (4) et le composant à semi-conducteur (3).

4. Agencement de circuit selon la revendication 1, le dispositif de liaison (4) chevauchant le composant à semi-conducteur (3) sur un bord (30) et la liaison avec la seconde piste conductrice (22b) étant réalisé ici.

5. Agencement de circuit selon la revendication 1, le dispositif de liaison (4) recouvrant une pluralité de composants à semi-conducteur (3).

6. Procédé pour fabriquer un agencement de circuit selon la revendication 1, présentant les étapes essentielles suivantes :
• réalisation d'une pluralité de surfaces de métal fritté (50, 52) sur des pistes conductrices (22 a/b) du substrat (2) ;
• agencement d'au moins un composant à semi-conducteur (3) sur une surface de métal fritté (52) associée ;
• agencement du matériau isolant (6) dans la zone de bordure (30) de l'au moins un composant à semi-conducteur (3) ;
• agencement du dispositif de liaison (4), qui est conçu sous forme de film métallique (40) ou d'assemblage de films constitué d'au moins un film métallique (40, 42) et d'un film isolant (44), pour la liaison électrique conforme au circuit de l'au moins un composant à semi-conducteur (3) et des pistes conductrices (22 a/b) du substrat (2) ;
• établissement d'une liaison à frittage sous pression entre le dispositif de liaison (4) et l'au moins un composant à semi-conducteur (3).

7. Procédé selon la revendication 6, une surface de métal fritté (54) étant réalisée sur la seconde surface principale du composant à semi-conducteur (3) avant la disposition sur le substrat (2).

8. Procédé selon la revendication 7, le matériau isolant (6) étant disposé avec un procédé d'injection ou de moulage.
